# EUROPEAN PATENT SPECIFICATION

(11) **EP 2 702 087 B1**
(45) Date of publication and mention of the grant of the patent: **18.03.2015**
(21) Application number: 12718127.9
(22) Date of filing: 17.04.2012
(51) Int. Cl.: C08G 61/12

(54) **SEMICONDUCTOR MATERIALS BASED ON THIENOTHIOPHENE-2,5-DIONE OLIGOMERS AND POLYMERS**
HALBLEITERMATERIALIEN AUF DER BASIS VON THIENOTHIOPHEN-2,5-DION-OLIGOMEREN UND POLYMEREN
MATÉRIAUX SEMI-CONDUCTEURS À BASE D'OLIGOMÈRES ET DE POLYMÈRES DE THIENOTHIOPHÈNE-2,5-DIONE

(30) Priority: 28.04.2011 US 201161479856 P; 28.04.2011 US 201161479859 P; 28.04.2011 EP 11164035
(43) Date of publication of application: 05.03.2014
(73) Proprietor: BASF SE, 67056 Ludwigshafen (DE)
(72) Inventor: MISHRA, Ashok Kumar, Singapore 140161 (SG); VAIDYANATHAN, Subramanian, 4057 Basel (CH); NOGUCHI, Hiroyoshi, Singapore 098830 (SG); DÖTZ, Florian, 68163 Mannheim (DE); ZHU, Bo, Shanghai 200062 (CN)
(74) Representative: Bernhardt, Wolfgang Willy-Hans
(86) International application number: PCT/EP2012/056957
(87) International publication number: WO 2012/146506

(56) References cited:
- WO-A1-2009/105042
- WO-A1-2009/123695
- US-A1- 2005 090 640

## Description

Organic semiconducting materials can be used in electronic devices such as organic photovoltaic devices (OPVs), organic field-effect transistors (OFETs), organic light emitting diodes (OLEDs), and organic eiectrochromic devices (ECDs).

For efficient and long lasting performance, it is desirable that the organic semiconducting material-based devices show high charge carrier mobility as well as high stability, in particular towards oxidation by air, under ambient environmental conditions.

Furthermore, it is desirable that the organic semiconducting materials are compatible with liquid processing techniques such as spin coating as liquid processing techniques are convenient from the point of processability, and thus allow the production of low cost organic semiconducting material-based electronic devices. In addition, liquid processing techniques are also compatible with plastic substrates, and thus allow the production of light weight and mechanically flexible organic semiconducting material-based electronic devices.

The use of polymeric organic semiconducting materials in electronic devices is known in the art.

Bao, Z.; Dobadalapur, A.; Lovinger, A. J. Appl. Phys. Lett. 1996, 69, 4108-4110 describes the use of regioregular poly(3-hexylthiophene) in field-effect transistors.

Zhang, M.; Tsao, H. N.; Pisula, W.; Yang, C.; Mishra, A. K.; Müllen, K. J. Am. Chem. Soc. 2007, 129, 3472-3473 describes polymers of formula 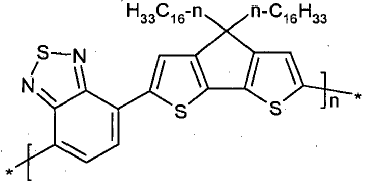 for use in organic field effect transistors (OFETs).

Ong, B. S.; Wu,Y.; Liu, P.; Gardner, S. J. Am. Chem. Soc. 2004, 126, 3378-3379 describes polymers of formula 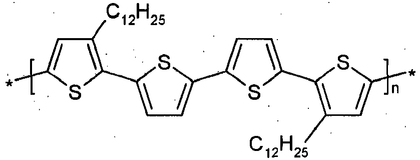 for use in organic field effect transistors (OFETs).

Zou, Y.; Najari, A.; Berrouard, P.; Beaupré, S.; Badrou, R. A.; Tao, Y.; Leclerc, M. J. Am. Chem. Soc. 2010, 132, 5330-5331 describes polymers of formula 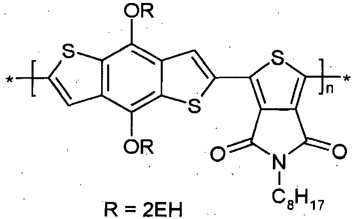 as donor materials for use in photovoltaic devices.

McCulloch, I.; Heeney, M.; Bailey, C.; Genevicius, K.; MacDonald, I.; Shkunov, M.; Sparrowe, D.; Tierney, S.; Wagner, R.; Zhang, W.; Chabinyc, M. L.; Kline, R. J.; McGehee, M. D.; Toney, M. F. Nat. Mater. 2006, 5(4), 328-333 describes polymers of formula 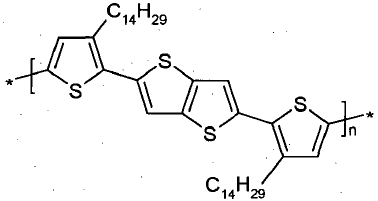 for use in organic field effect transistors (OFETs).

L. Bürgi, M. Turbiez, R. Pfeiffer, F. Bienewald, H.-J. Kirner, C. Winnewisser, Adv. Mater. 2008, 20, 2217-2224 describes polymers of formula 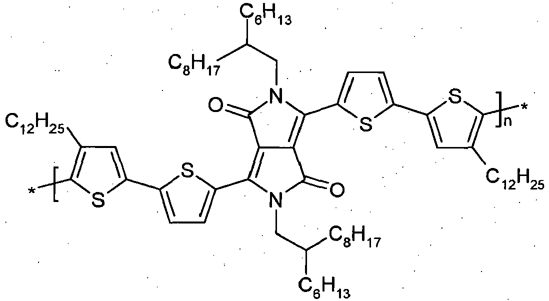 for use in organic field effect transistors (OFETs).

J. C. Bijleveld, A. P. Zoombelt, S. G. J. Mathijssen, M. M. Wienk, M. Turbiez, D. M. de Leeuw, R. A. J. Janssen, J. Am. Chem. Soc. 2009, 131, 16616-16617 describes polymers of formula 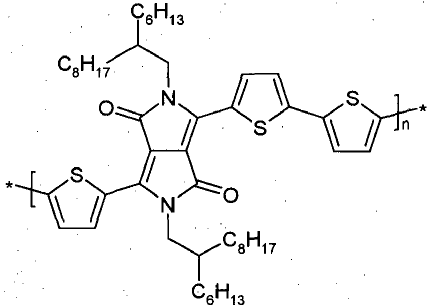 for use in organic field effect transistors (OFETs) and organic photovoltaic devices (OPVs).

Thienothiophene-2,5-dione monomers are known in the art.

JP 04-338761 describes a photoreceptor comprising an electrically conductive substrate having thereon a photosensitive layer, which photosensitive layer contains a charge-transporting compound selected from dibenzothiopyran, dihydrophenanthrene, thienothiophene, and indenoindene derivatives. The compound of formula III is an example of a thienothiophene-type charge-transporting compound.

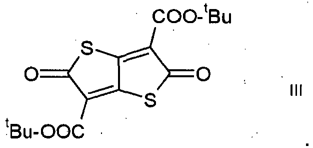

DE 39 17 323 A1 describes compounds of formula 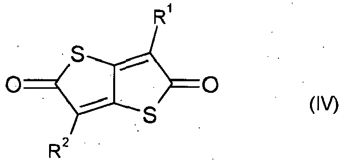 as precursors for the preparation of charge transfer complexes comprising a compound of formula

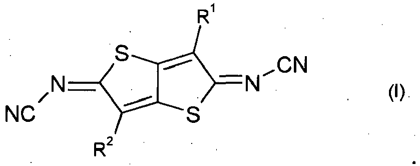

E. Günther, S. Hünig, Chem. Ber. 1992, 125, 1235-1241 describes compounds of formula 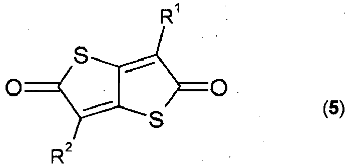 and their electrochemical properties.

It was the object of the present invention to provide new organic polymeric semiconducting materials.

This object is solved by the polymer of claim 1 and the electronic device of claim 11.

The organic polymeric semiconducting material of the present invention is a polymer comprising a unit of formula 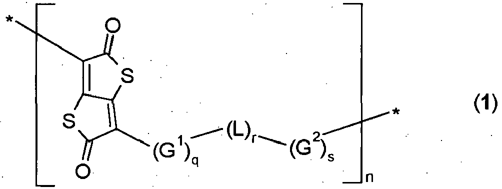 wherein
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀₋alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
   wherein
   R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl,-NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   or
G¹ and G² are independently from each other 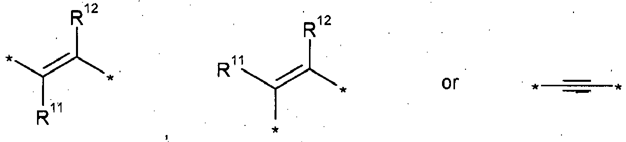 wherein
   R¹¹ and R¹² are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substitutents R^{e}, C₂₋₃₀-alkenyl optionally substituted with 1 to 6 substitutents R^{e}, C₂₋₃₀-alkynyl optionally substituted with 1 to 6 substitutents R^{e}, C₃₋₁₀-cycloalkyl optionally substituted with 1 to 6 substitutents R^{f}, C₅₋₁₀-cycloalkenyl optionally substituted with 1 to 6 substitutents R^{f} and monovalent 3 to 14 membered aliphatic heterocyclic residue optionally substituted with 1 to 6 substitutents R^{f},
   wherein
   R⁵ and R⁶ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   R^{e} at each occurrence are independently from each other selected from the group consisting of =O, =C(CN)₂, -O-C₂₋₆-alkylene-O-, halogen, -CN, -NO₂, -OH, C₁₋₁₀alkoxy, -O-CH₂CH₂O-C₁₋₁₀-alkyl, -O-COR⁷, -S-C₁₋₁₀alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R⁷ and R⁸ at each occurrence are independently from each other selected from the group consisting of C₁₋₁₀-alkyl, C₂₋₁₀alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   or
L is 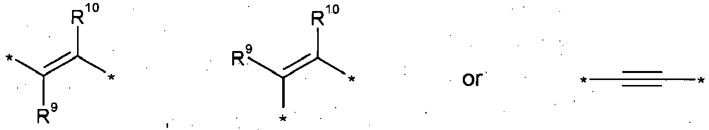 wherein
   R⁹ and R¹⁰ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

Preferably, the organic polymeric semiconducting material of the present invention is a polymer consisting essentially of a unit of formula 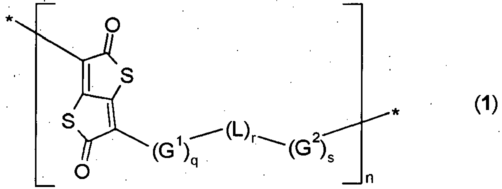 wherein
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyL, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
   wherein
   R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH2, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR3, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R³ and R⁴ at each occurrence are independently from each other selected from the group consisting of C₁₋₁₀-alkyl, C₂₋₁₀-alkenyl, C₂₋₁₀alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   or
G¹ and G² are independently from each other 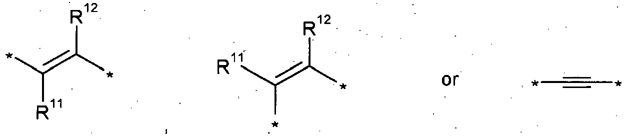 wherein
   R¹¹ and R¹² are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of = O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substitutents R^{e}, C₂₋₃₀-alkenyl optionally substituted with 1 to 6 substitutents R^{e}, C₂₋₃₀-alkynyl optionally substituted with 1 to 6 substitutents R^{e}, C₃₋₁₀-cycloalkyl optionally substituted with 1 to 6 substitutents R^{f}, C₅₋₁₀-cycloalkenyl optionally substituted with 1 to 6 substitutents R^{f} and monovalent 3 to 14 membered aliphatic heterocyclic residue optionally substituted with 1 to 6 substitutents R^{f},
   wherein
   R⁵ and R⁶ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   Re at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R⁷ and R⁸ at each occurrence are independently from each other selected from the group consisting of C₁₋₁₀alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue, or
L is 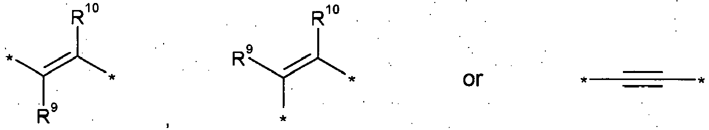 wherein
   R⁹ and R¹⁰ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

The term "consisting essentially of" means that at least 80% by weight, more preferably at least 90% by weight, of the polymer consists of a unit of formula (1) based on the weight of the polymer.

More preferably, the organic polymeric semiconducting material of the present invention is a polymer of formula 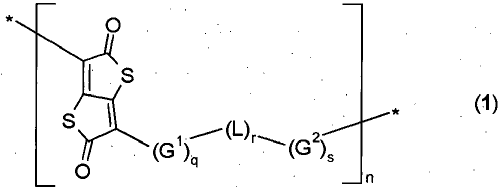 wherein
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
   wherein
   R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   Rc at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀alkynyl, C₆₋₁₄-aryl and monovalent 5 to 14 membered aromatic heterocyclic residue;
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆-₁₄-aryl and monovalent 5 to 14 membered aromatic heterocyclic residue,
   or
G¹ and G² are independently from each other 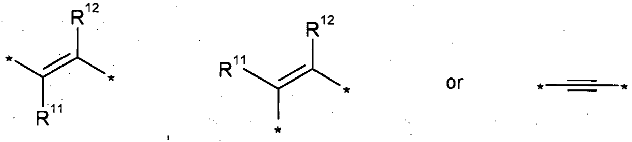 wherein
   R¹¹ and R¹² are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substitutents R^{e}, C₂₋₃₀-alkenyl optionally substituted with 1 to 6 substitutents R^{e}, C₂₋₃₀-alkynyl optionally substituted with 1 to 6 substitutents R^{e}, C₃₋₁₀-cycloalkyl optionally substituted with 1 to 6 substitutents R^{f}, C₅₋₁₀-cycloalkenyl optionally substituted with 1 to 6 substitutents R^{f} and monovalent 3 to 14 membered aliphatic heterocyclic residue optionally substituted with 1 to 6 substitutents R^{f},
   wherein
   R⁵ and R⁶ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{f} at each occurrence are independently from each other selected from the group consisting of =O, =C(CN)₂, -O-C₂₋₆-alkylene-O-, halogen, -CN, -NO₂, -OH, C₁₋₁₀alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR7R⁸, -CO-H, -COR⁷, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R⁷ and R⁸ at each occurrence are independently from each other selected from the group consisting of C₁₋₁₀-alkyl, C₂₋₁₀-alkenyl, C₂₋₁₀alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   or
L is 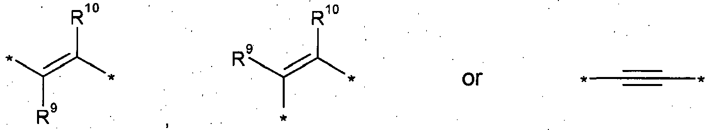 wherein
   R⁹ and R¹⁰ are independently from each other H, C₁₋₃₀-alkyl, -CN or halogen,
q and s are independently from each other 0, 1, 2, 3, 4 or 5,
r is 0, 1 or 2,
   and
n is an integer from 2 to 10'000.

C₁₋₁₀-alkyl and C₁₋₃₀-alkyl can be branched or unbranched. Examples of C₁₋₁₀-alkyl are methyl, ethyl, *n*-propyl, isopropyl, *n*-butyl, *sec*-butyl, isobutyl, *tert*-butyl, *n*-pentyl, neopentyl, isopentyl, *n*-(1-ethyl)propyl, *n*-hexyl, *n*-heptyl, *n*-octyl, *n*-(2-ethyl)hexyl, *n*-nonyl and *n*-decyl. Examples of C₁₋₃₀-alkyl are C₁₋₁₀-alkyl, and *n*-undecyl, *n*-dodecyl, *n*-undecyl, *n*-dodecyl, *n*-tridecyl, *n*-tetradecyl, *n*-pentadecyl, *n*-hexadecyl, *n*-heptadecyl, *n*-octadecyl, *n*-nonadecyl and *n*-icosyl (C₂₀), *n*-docosyl (C₂₂), *n*-tetracosyl (C₂₄), *n*-hexacosyl (C₂₆), *n*-octacosyl (C₂₈) and *n*-triacontyl (C₃₀). Examples of C₆₋₂₀-alkyl are *n*-hexyl, *n*-heptyl, *n*-octyl, *n*-(2-ethyl)hexyl, *n*-nonyl, *n*-decyl, *n*-undecyl, *n*-dodecyl, *n*-undecyl, *n*-dodecyl, *n*-tridecyl, *n*-tetradecyl, *n*-pentadecyl, *n*-hexadecyl, *n*-heptadecyl, *n*-octadecyl, *n*-nonadecyl and *n*-icosyl (C₂₀). Examples of C₈₋₁₆-alkyl are *n*-octyl, *n*-(2-ethyl)hexyl, *n*-nonyl, *n*-decyl, *n*-undecyl, *n*-dodecyl, *n*-undecyl, *n*-dodecyl, *n*-tridecyl, n-tetradecyl, *n*-pentadecyl, and *n*-hexadecyl.

C₂₋₁₀-alkenyl and C₂₋₃₀-alkenyl can be branched or unbranched. Examples of C₂₋₁₀-alkenyl are vinyl, propenyl, *cis*-2-butenyl, *trans*-2-butenyl, 3-butenyl, *cis*-2-pentenyl, *trans*-2-pentenyl, *cis*-3-pentenyl, *trans*-3-pentenyl, 4-pentenyl, 2-methyl-3-butenyl, hexenyl, heptenyl, octenyl, nonenyl and docenyl. Examples of C₂₋₃₀-alkenyl are C₂₋₁₀-alkenyl, and linoleyl (C₁₈), linolenyl (C₁₈), oleyl (C₁₈), arachidonyl (C₂₀), and erucyl (C₂₂).

C₂₋₁₀-alkynyl and C₂₋₃₀-alkynyl can be branched or unbranched. Examples of C₂₋₁₀-alkynyl are ethynyl, 2-propynyl, 2-butynyl, 3-butynyl, pentynyl, hexynyl, heptynyl, octynyl, nonynyl and decynyl. Examples of C₂₋₃₀-alkynyl are C₂₋₁₀-alkynyl, and undecynyl, dodecynyl, undecynyl, dodecynyl, tridecynyl, tetradecynyl, pentadecynyl, hexadecynyl, heptadecynyl, octadecynyl, nonadecynyl and icosynyl (C₂₀).

Examples of C₃₋₁₀-cycloalkyl are preferably monocyclic C₃₋₁₀cycloalkyls such as cyclopropyl, cyclobutyl, cyclopentyl, cyclohexyl, cycloheptyl and cyclooctyl, but include also polycyclic C₃₋₁₀-cycloalkyls such as decalinyl, norbornyl and adamantyl.

Examples of C₅₋₁₀-cycloalkenyl are preferably monocyclic C₅₋₁₀-cycloalkenyls such as cyclopentenyl, cyclohexenyl, cyclohexadienyl and cycloheptatrienyl, but include also polycyclic C₅₋₁₀-cycloalkenyls.

Examples of monovalent 3 to 14 membered aliphatic heterocyclic residues are monocyclic monovalent 3 to 8 membered aliphatic cyclic residues and polycyclic, for example bicyclic monovalent 7 to 12 membered aliphatic heterocyclic residues.

Examples of monocyclic monovalent 3 to 8 membered aliphatic heterocyclic residues are monocyclic monovalent 5 membered aliphatic heterocyclic residues containing one heteroatom such as pyrrolidinyl, 1-pyrrolinyl, 2-pyrrolinyl, 3-pyrrolinyl, tetrahydrofuryl, 2,3-dihydrofuryl, tetrahydrothiophenyl and 2,3-dihydrothiophenyl, monocyclic monovalent 5 membered aliphatic heterocyclic residues containing two heteroatoms such as imidazolidinyl, imidazolinyl, pyrazolidinyl, pyrazolinyl, oxazolidinyl, oxazolinyl, isoxazolidinyl, isoxazolinyl, thiazolidinyl, thiazolinyl, isothiazolidinyl and isothiazolinyl, monocyclic monovalent 5 membered aliphatic heterocyclic residues containing three heteroatoms such as 1,2,3-triazolyl, 1,2,4-triazolyl and 1,4,2-dithiazolyl, monocyclic monovalent 6 membered aliphatic heterocyclic residues containing one heteroatom such as piperidyl, piperidino, tetrahydropyranyl, pyranyl, thianyl and thiopyranyl, monocyclic monovalent 6 membered aliphatic heterocyclic residues containing two heteroatoms such as piperazinyl, morpholinyl and morpholino and thiazinyl, monocyclic monovalent 7 membered aliphatic heterocyclic residues containing one hereoatom such as azepanyl, azepinyl, oxepanyl, thiepanyl, thiapanyl, thiepinyl, and monocyclic monovalent 7 membered aliphatic heterocyclic residues containing two hereoatom such as 1,2-diazepinyl and 1,3-thiazepinyl.

An example of a bicyclic monovalent 7-12 membered aliphatic heterocyclic residue is decahydronaphthyl.

C₆₋₁₄-aryl can be monocyclic or polycyclic. Examples of C₆₋₁₄-aryl are monocyclic C₆-aryl such as phenyl, bicyclic C₉₋₁₀-aryl such as 1-naphthyl, 2-naphthyl, indenyl, indanyl and tetrahydronaphthyl, and tricyclic C₁₂₋₁₄-aryl such as anthryl, phenanthryl, fluorenyl and s-indacenyl.

The monovalent 5 to 14 membered aromatic heterocyclic residues can be monocyclic monovalent 5 to 8 membered aromatic heterocyclic residues, or polycyclic, for example bicyclic monovalent 7 to 12 membered, tricyclic monovalent 9 to 14 membered aromatic heterocyclic residue, or tetracyclic monovalent 9 to 14 membered aromatic heterocyclic residues.

Examples of monocyclic monovalent 5 to 8 membered aromatic heterocyclic residues are monocyclic monovalent 5 membered aromatic heterocyclic residues containing one heteroatom such as pyrrolyl, furyl and thiophenyl, monocyclic monovalent 5 membered aromatic heterocyclic residues containing two heteroatoms such as imidazolyl, pyrazolyl, oxazolyl, isoxazolyl, thiazolyl, isothiazolyl, monocyclic monovalent 5 membered aromatic heterocyclic residues containing three heteroatoms such as 1,2,3-triazolyl, 1,2,4-triazolyl and oxadiazolyl, monocyclic monovalent 5 membered aromatic heterocyclic residues containing four heteroatoms such as tetrazolyl, monocyclic monovalent 6 membered aromatic heterocyclic residues containing one heteroatom such as pyridyl, monocyclic monovalent 6 membered aromatic heterocyclic residues containing two heteroatoms such as pyrazinyl, pyrimidinyl and pyridazinyl, monocyclic monovalent 6 membered aromatic heterocyclic residues containing three heteroatoms such as 1,2,3-triazinyl, 1,2,4-triazinyl and 1,3,5-triazinyl, monocyclic monovalent 7 membered aromatic heterocyclic residues containing one heteroatom such as azepinyl, and monocyclic monovalent 7 membered aromatic heterocyclic residues containing two heteroatoms such as 1,2-diazepinyl,

Examples of bicyclic monovalent 7 to 12 membered aromatic heterocyclic residues are bicyclic monovalent 8 membered aromatic heterocyclic residues containing two heteroatoms such as thieno[3,2-b]thiophenyl, bicyclic 9 membered aromatic heterocyclic residues containing one heteroatom such as indolyl, isoindolyl, indolizinyl, indolinyl, benzofuryl, isobenzofuryl, benzothiophenyl and isobenzothiophenyl, bicyclic monovalent 9 membered aromatic heterocyclic residues containing two heteroatoms such as indazolyl, benzimidazolyl, benzimidazolinyl, benzoxazolyl, benzisooxazolyl, benzthiazolyl, benzisothiazolyl, furopyridyl and thienopyridyl, bicyclic monovalent 9 membered aromatic heterocyclic residues containing three heteroatoms such as benzotriazolyl, benzoxadiazolyl, oxazolopyridyl, isooxazolopyridyl, thiazolopyridyl, isothiazolopyridyl and imidazopyridyl, bicyclic monovalent 9 membered aromatic heterocyclic residues containing four heteroatoms such as purinyl, bicyclic monovalent 10 membered aromatic heterocyclic residues containing one heteroatom such as quinolyl, isoquinolyl, chromenyl and chromanyl, bicyclic monovalent 10 membered aromatic heterocyclic residues containing two heteroatoms such as quinoxalinyl, quinazolinyl, cinnolinyl, phthalazinyl, 1,5-naphthyridinyl and 1,8-naphthyridinyl, bicyclic monovalent 10 membered aromatic heterocyclic residues containing three heteroatoms such as pyridopyrazinyl, pyridopyrimidinyl and pyridopyridazinyl, and bicyclic monovalent 10 membered aromatic heterocyclic residues containing four heteroatoms such as pteridinyl.

Examples of tricyclic monovalent 9 to 14 membered aromatic heterocyclic residues are dibenzofuryl, acridinyl, phenoxazinyl, 7H-cyclopenta[1,2-b:3,4-b']dithiophenyl and 4H-cyclopenta-[2,1-b:3,4-b']dithiophenyl. An example of a tricyclic monovalent 9 to 14 membered aromatic heterocyclic residue containing three heteroatoms is dithienothiophenyl of formula

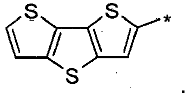

An example of a tricyclic monovalent 9 to 14 membered aromatic heterocyclic residue containing four heteroatoms is trithienothiophenyl of formula

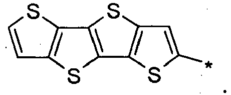

Examples of halogen are -F, -Cl, -Br and -I.

Examples of C₁₋₁₀-alkoxy are methoxy, ethoxy, *n*-propoxy, isopropoxy, *n*-butoxy, *sec*-butoxy, isobutoxy, *tert*-butoxy, *n*-pentoxy, neopentoxy, isopentoxy, hexoxy, *n*-heptoxy, *n*-octoxy, *n*-nonoxy and *n*-decoxy. Examples of C₁₋₃₀-alkoxy are C₁₋₁₀-alkoxy, and *n*-undecoxy, *n*-dodecoxy, *n*-undecoxy, *n*-dodecoxy, *n*-tridecoxy, *n*-tetradecoxy, *n*-pentadecoxy, *n-*hexadecoxy, *n*-heptadecoxy, *n*-octadecoxy, *n*-nonadecoxy and *n*-icosoxy (C₂₀), *n*-docosoxy (C₂₂), *n*-tetracosoxy (C₂₄), *n*-hexacosoxy (C₂₆), *n*-octacosoxy (C₂₈) and *n*-triacontoxy (C₃₀).

Examples of C₂₋₆-alkylene are ethylene, butylene, pentylene, hexylene and 2-methylpentylene.

Examples of C₆₋₁₄-arylene are monocyclic C₆-arylene such as phenylene, bicyclic C₉₋₁₀-arylene such as naphthylene, for example 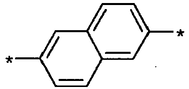 indenylene, for example 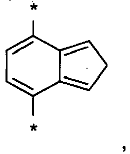 indanylene, for example 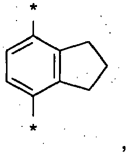 and tetrahydronaphthylene, for example 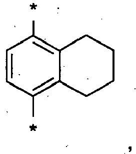 and tricyclic C₁₂₋₁₄-arylene such as anthrylene, for example 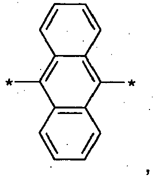 phenanthrylene, for example 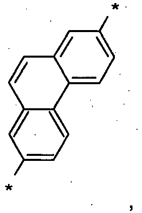 fluorenylene, for example 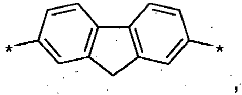 and
*s*-indacenylene, for example

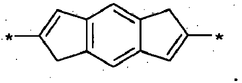

Examples of C₆₋₂₄-arylene are C₆₋₁₄-arylene and 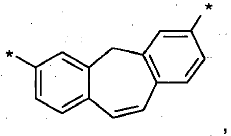 pyrenylene, for example 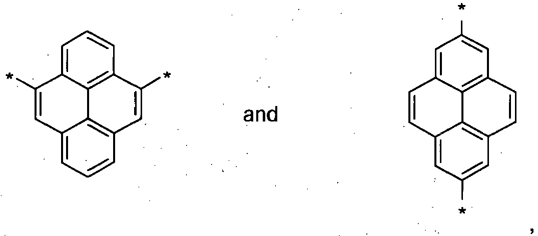 tetracenylene, for example 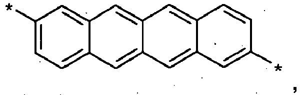 perylenylene, for example 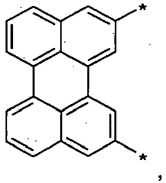 indenofluorenylene, for example 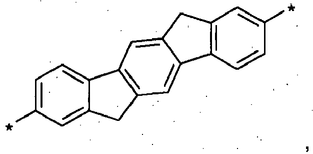 pentacenylene, for example 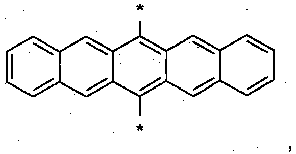 coronenylene, for example 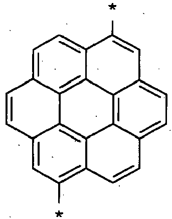 and tetraphenylenylene, for example

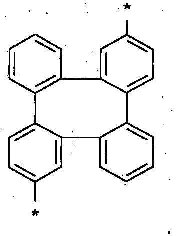

The bivalent 5 to 14 membered aromatic heterocyclic residues can be monocyclic bivalent 5 to 8 membered aromatic heterocyclic residues, or polycyclic, for example bicyclic bivalent 7 to 14 membered, tricyclic bivalent 9 to 14 membered aromatic heterocyclic residues, or tetracyclic bivalent 9 to 14 membered aromatic heterocyclic residues.

Examples of monocyclic bivalent 5 to 8 membered aromatic heterocyclic residues are monocyclic bivalent 5 membered aromatic heterocyclic residues containing one heteroatom such as pyrrolylene, furylene and thiophenylene, monocyclic bivalent 5 membered aromatic heterocyclic residues containing two heteroatoms such as imidazolylene, pyrazolylene, oxazolylene, isoxazolylene, thiazolylene, isothiazolylene, monocyclic bivalent 5 membered aromatic heterocyclic residues containing three heteroatoms such as 1,2,3-triazolylene, 1,2,4-triazolylene and oxadiazolylene, monocyclic bivalent 5 membered aromatic heterocyclic residues containing four heteroatoms such as tetrazolylene, monocyclic bivalent 6 membered aromatic heterocyclic residues containing one heteroatom such as pyridylene, monocyclic bivalent 6 membered aromatic heterocyclic residues containing two heteroatoms such as pyrazinylene, pyrimidinylene and pyridazinylene, monocyclic bivalent 6 membered aromatic heterocyclic residues containing three heteroatoms such as 1,2,3-triazinylene, 1,2,4-triazinylene and 1,3,5-triazinylene, monocyclic bivalent 7 membered aromatic heterocyclic residues containing one heteroatom such as azepinylene, and monocyclic bivalent 7 membered aromatic heterocyclic residues containing two heteroatoms such as 1,2-diazepinylene.

Examples of bicyclic bivalent 7 to 14 membered aromatic heterocyclic residues are bicyclic bivalent 8 membered aromatic heterocyclic residues containing two heteroatoms such as thienothiophenylene, for example 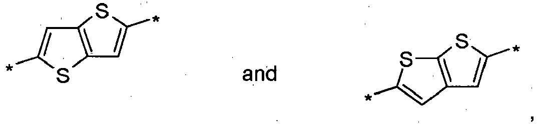 bicyclic bivalent 8 membered aromatic heterocyclic residues containing three heteroatoms such as as thienothiazolylene, for example 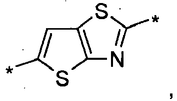 bicyclic bivalent 8 membered aromatic heterocyclic residues containing four heteroatoms such as thiazothiazolylene, for example 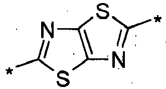 bicyclic bivalent 9 membered aromatic heterocyclic residues containing one heteroatom such as indolylene, isoindolylene, indolizinylene, indolinylene, isoindolinylene, for example 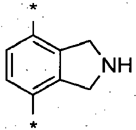 benzofurylene, isobenzofurylene, benzothiophenylene and isobenzothiophenylene,
bicyclic bivalent 9 membered aromatic heterocyclic residues containing two heteroatoms such as indazolylene, benzimidazolylene, benzimidazolinylene, benzoxazolylene, benzisooxazolylene, benzthiazolylene, benzisothiazolylene, furopyridylene and thienopyridylene,
bicyclic bivalent 9 membered aromatic heterocyclic residues containing three heteroatoms such as benzotriazolylene, benzoxadiazolylene, oxazolopyridylene, isooxazolopyridylene, thiazolopyridylene, isothiazolopyridylene, imidazopyridylene, benzothiadiazolylene, for example 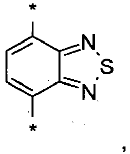 and dioxanothiophenylene, for example 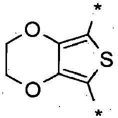 bicyclic bivalent 9 membered aromatic heterocyclic residues containing four heteroatoms such as purinylene,
bicyclic bivalent 10 membered aromatic heterocyclic residues containing one heteroatom such as quinolylene, isoquinolylene, chromenylene and chromanylene,
bicyclic bivalent 10 membered aromatic heterocyclic residues containing two heteroatoms such as quinoxalinylene, for example 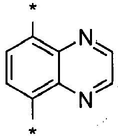 quinazolinylene, cinnolinylene, phthalazinylene, 1,5-naphthyridinylene and 1,8-naphthyridinylene,
bicyclic bivalent 10 membered aromatic heterocyclic residues containing three heteroatoms such as pyridopyrazinylene, pyridopyrimidinylene and pyridopyridazinylene, and bicyclic bivalent 10 membered aromatic heterocyclic residues containing four heteroatoms such as pteridinylene.

Examples of tricyclic bivalent 9 to 14 membered aromatic heterocyclic residues containing one heteroatom are dibenzofurylene, acridinylene, dibenzosilacyclopentadienylene, for example 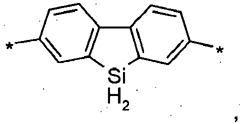 and dibenzopyrrolylene, for example

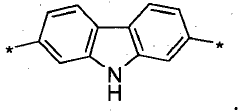

Examples of a tricyclic bivalent 9 to 14 membered aromatic heterocyclic residues containing two heteroatoms are phenoxazinylene, and the following compounds 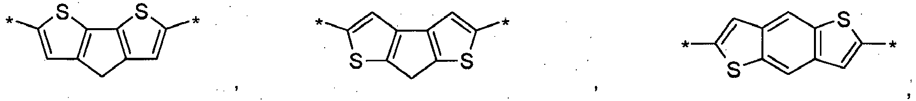 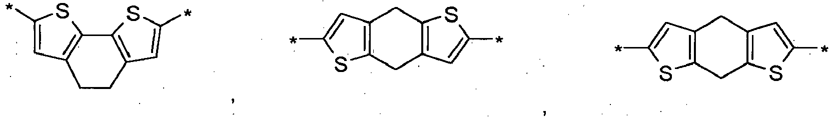 and

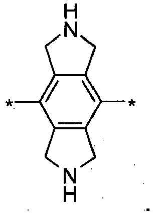

Examples of tricyclic bivalent 9 to 14 membered aromatic heterocyclic residue containing three heteroatoms are the following compounds

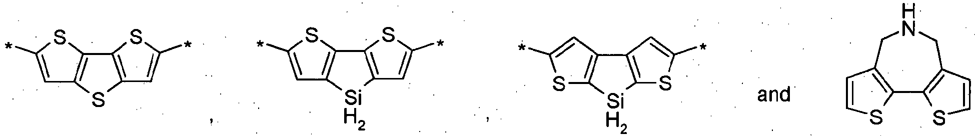

Examples of tricyclic bivalent 9 to 14 membered aromatic heterocyclic residue containing four-heteroatoms are the following compounds

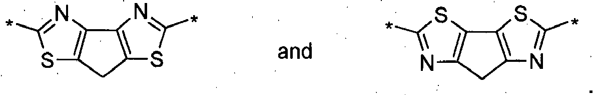

An example of a tricyclic bivalent 9 to 14 membered aromatic heterocyclic residue containing six heteroatoms is the following compound

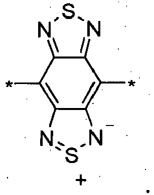

An example of a tetracyclic bivalent 9 to 14 membered aromatic heterocyclic residue containing four heteroatoms is the following compound

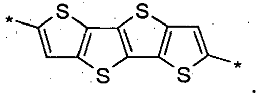

Examples of bivalent 5 to 24 membered aromatic heterocyclic residues are bivalent 5 to 14 membered aromatic heterocyclic residues, and the following compounds

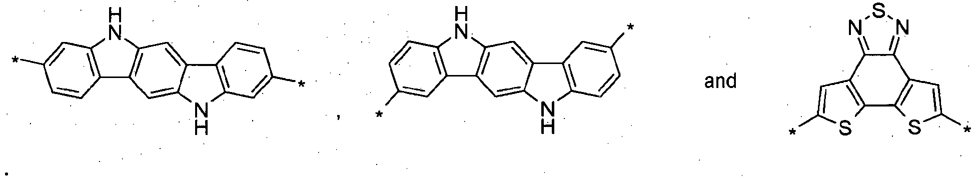

Examples of L are:

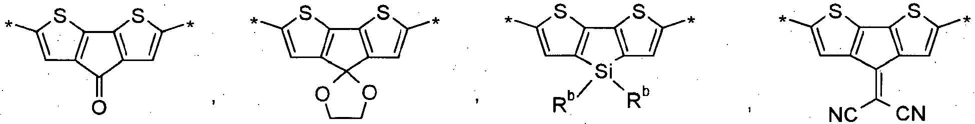

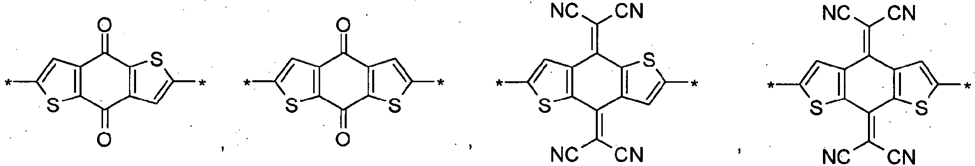

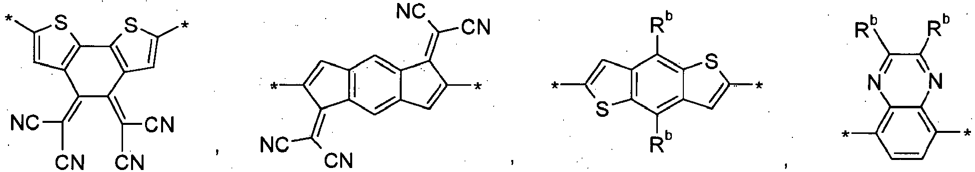

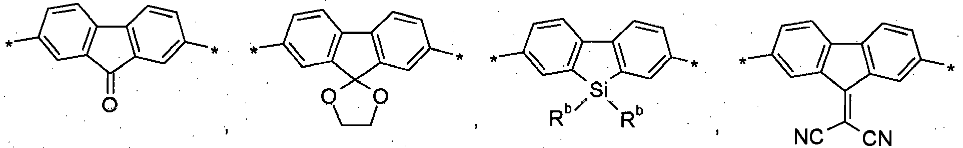

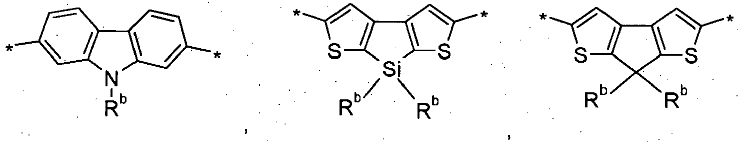

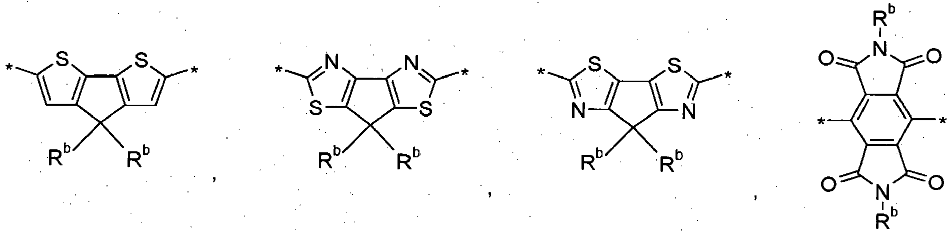

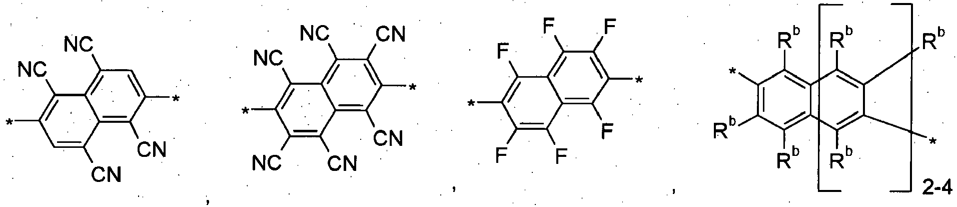

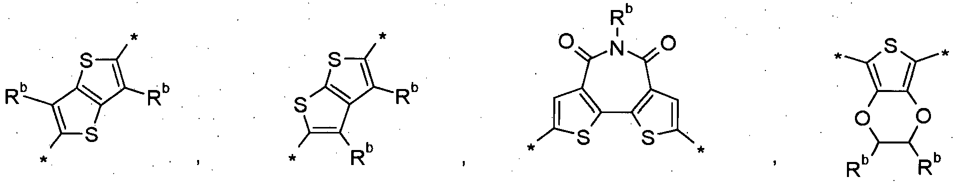

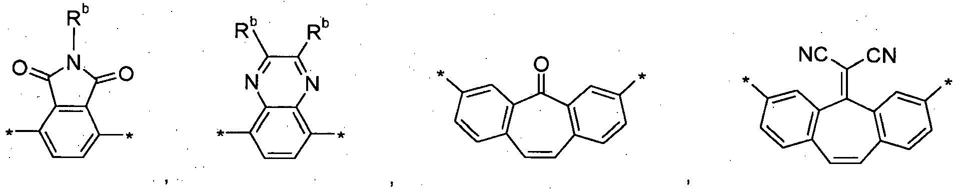

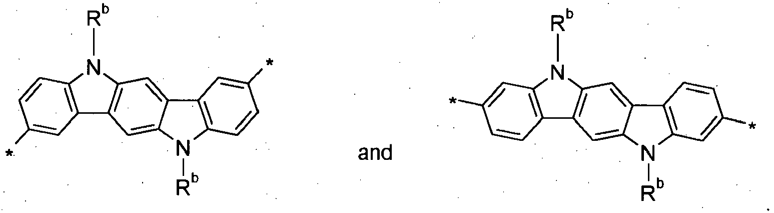

In preferred units of formula (1)
G¹ and G² are independently from each other bivalent 5 to 14 membered aromatic heterocyclic residue optionally substituted with 1 to 6 substituents R^{a},
   wherein
   R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
   wherein
   R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to 14 membered aromatic heterocyclic residue,
   Rc at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl, and monovalent 5 to14 membered aromatic heterocyclic residue,
L is bivalent 5 to 24 membered aromatic heterocyclic residue optionally substituted with 1 to 6 substituents R^{b},
   wherein
   R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substituents R^{e}, C₂₋₃₀-alkenyl optionally substituted with 1 to 6 substituents R^{e}, C₂₋₃₀-alkynyl optionally substituted with 1 to 6 substituents R^{e}, C₃₋₁₀-cycloalkyl optionally substituted with 1 to 6 substituents R^{f}, C₅₋₁₀-cycloalkenyl optionally substituted with 1 to 6 substituents R^{f} and monovalent 3 to 14 membered aliphatic heterocyclic residue optionally substituted with 1 to 6 substituents R^{f},
   wherein
   R⁵ and R⁶ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀₋alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
   R^{f} at each occurrence are independently from each other selected from the group consisting of =O, =C(CN)₂, -O-C₂₋₆-alkylene-O-, halogen, -CN, -NO₂, -OH, C₁₋₁₀alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-alkyl, C₂₋₁₀-alkenyl, C₂₋₁₀-alkynyl, C₆₋₁₄-aryl and monovalent 5 to 14 membered aromatic heterocyclic residue;
   wherein R⁷ and R⁸ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
   or
L is 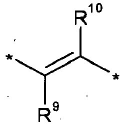 wherein
   R⁹ and R¹⁰ are independently from each other H, C₁₋₃₀-alkyl, -CN or halogen,
q and s are independently from each other 0, 1, 2, 3, 4 or 5,
r is 0, 1 or 2,
   and
n is an integer from 5 to 10'000.

In more preferred units of formula (1)
G¹ and G² are independently from each other monocyclic bivalent 5 to 8 membered aromatic heterocyclic residue optionally substituted with 1 to 4 substituents R^{a},
   wherein
   R^{a} at each occurrence are independently from each C₁₋₃₀-alkyl, preferably C₆₋₂₀-alkyl, more preferably C₈₋₁₆-alkyl,
L is monocyclic bivalent 5 to 8 membered aromatic heterocyclic residue optionally substituted with 1 to 4 substituents R^{b},
   wherein
   R^{b} at each occurrence are independently from each other C₁₋₃₀-alkyl,
q and s are both 1,
r is 2,
   and
n is an integer from 5 to 10'000.

Particular preferred units of formula (1) are units of formula 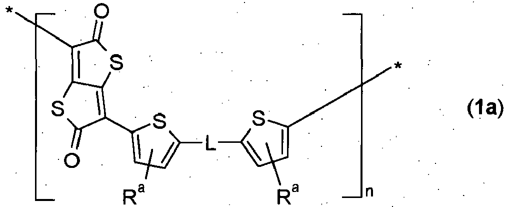 wherein R^{a} and L are as defined above.

In particular preferred units of formula (1a)
L is

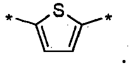

Preferably, n is an integer from 5 to 5'000, more preferably from 5 to 1'000, even more preferably from 5 to 100, and most preferably from 10 to 100.

A particular preferred example of the units of formulae (**1**) and (**1a**) is the unit of formula 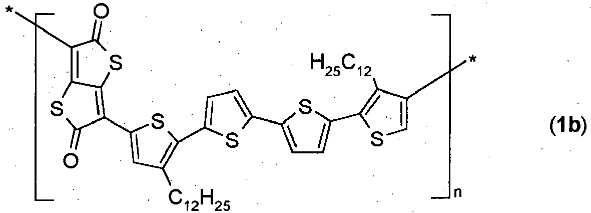 wherein n is an integer from 10 to 1000, preferably from 10 to 100.

The organic polymeric semiconducting material of the present invention can be a polymer comprising preferably at least 80% by weight, more preferably at least 90% by weight, of a unit of formula (**1**), respectively, (**1a**) based on the weight of the polymer.

Most preferably, the organic polymeric semiconducting material of the present invention is a polymer consisting essentially of a unit of formula (1), respectively, (**1a**).

The polymer comprising a unit of formula (1) can be prepared by treating a compound of formula 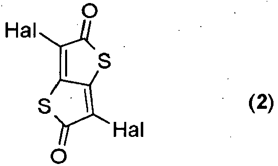 wherein Hal is halogen, preferably -Br,
with a compound of formula 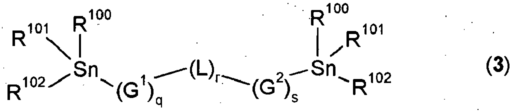 wherein G¹, G², L, q, rand s are as defined above, and R¹⁰⁰, R¹⁰¹ and R¹⁰² are independently from each other C₁₋₁₀-alkyl, preferably methyl.
in the presence of transition metal catalyst.

The transition metal catalyst is preferably a palladium catalyst such tris(dibenzylideneacetone)-dipalladium(0), preferably in combination with a phosphine such as tri-o-tolylphosphine. The reaction is preferably performed at elevated temperatures such 80 to 200 °C, preferably 90 to 150 °C. The reaction can be performed in an inert organic solvent such as chlorobenzene. The reaction can be stopped by the addition of end cappers such as 2-bromothiophene and 2-tributylstannylthiophene. The crude product may be worked up by conventional methods, for example compound (**1**) may be isolated from the reaction mixture by precipitation, for example by pouring the reaction mixture into methanol. The so obtained compound (**1**) may be further purified by extracting it with an appropriate solvent, for example with acetone.

The compound of formula (2) can be prepared by methods known in the art, for example as described in E. Günther, S. Hünig, Chem. Ber. 1992, 125, 1235-1241.

Also part of the present invention is an electronic device comprising the polymer comprising a unit of formula (1) as semiconducting material. Preferably, the electronic device is an organic field effect transistor (OFET), and in particular a thin film transistor (TFT). Preferably, the electronic device is an organic photovoltaic device (OPV).

Usually, an organic field effect transistor comprises a dielectric layer, a semiconducting layer and a substrate. In addition, on organic field effect transistor usually comprises a gate electrode and source/drain electrodes.

An organic field effect transistor can have various designs.

The most common design of a field-effect transistor is the Bottom-Gate Top-Contact (BGTC) design. Here, the gate is on top of the substrate and at the bottom of the dielectric layer, the semiconducting layer is at the top of the dielectric layer and the source/drain electrodes are on top of the semiconducting layer.

Another design of a field-effect transistor is the Top-Gate Bottom-Contact (TGBC) design. Here, the source/drain electrodes are on top of the substrate and at the bottom of the semiconducting layer, the dielectric layer is on top of the semiconducting layer and the gate electrode is on top of the dielectric layer.

The semiconducting layer comprises the organic polymeric semiconducting material of the present invention. The semiconducting layer can have a thickness of 5 to 500 nm, preferably of 10 to 100 nm, more preferably of 20 to 50 nm.

The dielectric layer comprises a dielectric material. The dielectric material can be silicium/silicium dioxide, or, preferably, an organic polymer such as polystyrene (PS), poly(methyl-methacrylate) (PMMA), poly(4-vinylphenol) (PVP), poly(vinyl alcohol) (PVA), anzocyclobutene (BCB), or polyimide (PI). The dielectric layer can have a thickness of 10 to 2000 nm, preferably of 50 to 1000 nm, more preferably of 100 to 800 nm.

The source/drain contacts and the gate contact can be made from any suitable material, for example Au.

The substrate can be any suitable substrate such as glass, or a plastic substrate. Preferably the substrate is a plastic substrate such as polyethersulfone, polycarbonate, polysulfone, polyethylene terephthalate (PET) and polyethylene naphthalate (PEN). More preferably, the plastic substrate is a plastic foil.

The organic field effect transistor can be prepared by methods known in the art.

For example, a top-gate bottom-contact (TGBC) thin film transistors (TFTs) can be prepared as follows: first: the source/drain contacts are placed on the substrate, for example by thermal evaporation of the source/drain material; second: the substrate is coated with the semiconducting layer, for example by spin-coating a solution of the semiconducting material in a suitable solvent and drying the semiconducting layer at elevated temperatures, for example at 80 to 100 °C; third: the semiconducting layer is coated with a solution of the dielectric material in a suitable solvent, for example by spin-coating a solution of the dielectric material and drying the dielectric layer at elevated temperatures, for example at 80 to 100 °C; fourth: the gate contact is placed on top of the dielectric layer, for example by thermal evaporation of the gate material.

Also part of the present invention is the use of the polymer comprising the unit of formula (1) as semiconducting material.

Electronic devices comprising the organic polymeric semiconducting materials of the present invention show high charge carrier mobility as well as high stability, in particular towards oxidation by air, under ambient environmental conditions.

In addition, the organic polymeric semiconducting materials of the present invention are compatible with liquid processing techniques such as spin coating and thus allow the production of low cost, light weight and flexible electronic devices.

### Examples

### Example 1

### Preparation of compound 5

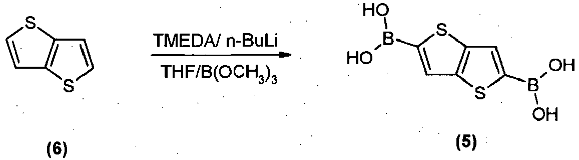

Thienothiophene (**6**) (5 g, 35.7 mmol) and tetramethylethylenediamine (16 mL, 107 mmol) are dissolved in THF (100 mL), degassed and charged with nitrogen. n-BuLi (56 mL, 1.6 M, 89.1 mmol) are added slowly at -78 °C. The mixture is stirred for 2.5 hours, and then the mixture is allowed to warm to room temperature. The mixture is stirred at room temperature for another 0.5 hours. The mixture is cooled to -78 °C, and trimethyl borate (16 mL, 143 mmol) is added. The color of the solution changes to orange red. The reaction mixture is stirred overnight and quenched with 5N aqueous HCl (20 mL). The reaction mixture is extracted with THF and diethyl ether. The organic layers are collected, washed with cold 2N aqueous NaOH (2 x 100 mL) and with brine, and dried over anhydrous Na₂SO₄. The solvent is removed, and the residue is dried under vacuum to yield compound **5**.

### Example 2

### Preparation of compound 4

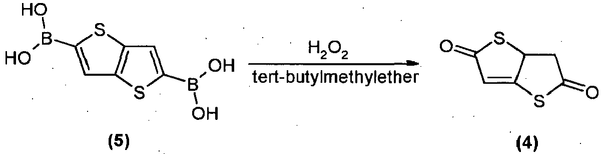

Hydrogen peroxide (20 mL) is slowly added to a dispersion of compound 5, prepared as described in example 1, in *tert*-butylmethyl ether (60 mL) at 0 °C. The mixture is stirred overnight at room temperature. The reaction mixture is then washed twice with cold FeSO₄ aqueous solution. The reaction mixture is extracted with THF and diethyl ether. The organic layers are collected and dried over anhydrous Na₂SO₄. The solvent is removed and the residue dried under vacuum to yield compound **4** as black solid.

### Example 3

### Preparation of thieno[3,2-b]thiophene-2,5-dione (3)

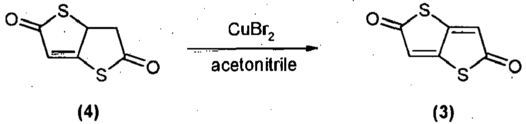

Compound **4** prepared as described in example 2 is dissolved in acetonitrile (150 mL). A solution of CuBr₂ (11 g, 471 mmol) in acetonitrile (80 mL) is added at 0 °C and the reaction mixture is stirred at room temperature overnight. The solvent is then removed, and the residue is redissolved in dichloromethane and filtered. The resulting solution is concentrated and dried. Crude compound **3** is purified on silica gel column chromatography using dichloromethane/n-hexane (1/1) as eluent, and recrystallized from hexane to give thieno[3,2-b]thiophene-2,5-dione (**3**) as green yellow crystals. ¹H-NMR (CDCl₃, 400 MHz) ppm 8.09 (s, 2H). ¹³C-NMR (CDCl₃) (100 MHz) ppm 187.741, 162.399, 122.180.

### Example 4

### Preparation of compound 2a

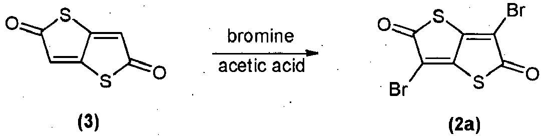

Thieno[3,2-b]thiophene-2,5-dione (3) (100 mg, 0.59 mmol) is dissolved in acetic acid (25 mL), and bromine (0.8 mL, 15 mmol) is added. The reaction mixture is stirred at 60 °C for 36 hours with the addition of bromine (0.8 mL, 15 mmol) again after 24 hours. The reaction is quenched by adding a solution of sodium thiosulfate and cooled to room temperature, any volatiles are distilled under reduced pressure. The remaining residue is dissolved in THF, filtered and flushed rapidly through a short silica gel column using THF as eluent. After the solvent is removed, crude compound **2a** is recrystalized from THF/ethanol (1/10) to give compound **2a** as a brown crystal (105 mg, 54%). ¹³C-NMR (THF) (100 MHz) ppm 181.349, 158.667, 117.855.

### Example 5

### Preparation of polymer P1 essentially consisting of the unit of formula 1b

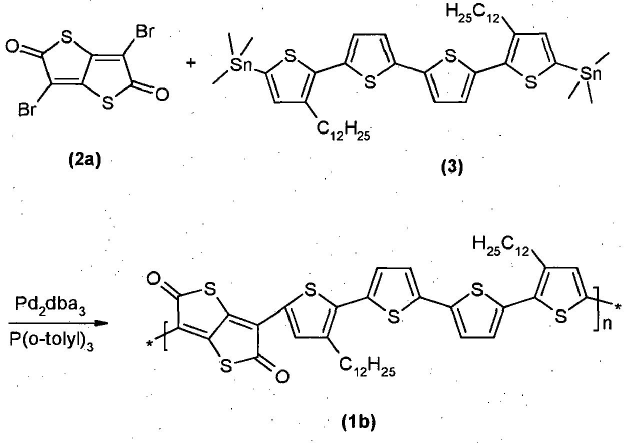

Tris(dibenzylideneacetone)dipalladium(0) (6.3 mg, 0.007 mmol) and tri(o-tolyl)phosphine (4.2 mg, 0.01 mmol) are added to a solution of compound **2a** prepared as described in example 4 (75 mg, 0.23 mmol) and compound **3** (228 mg, 0.23 mmol) in anhydrous chlorobenzene (7.7 mL) under nitrogen. The resulting mixture is refluxed for 2 days under nitrogen. The mixture is cooled to room temperature, poured into methanol (300 mL) and stirred for 2 hours at room temperature. The precipitate is filtered and washed with methanol and subjected to Soxhlet extraction in acetone. The precipitate is then dissolved in toluene and precipitated with methanol to obtain polymer **P1**.

## Claims

1. A polymer comprising a unit of formula 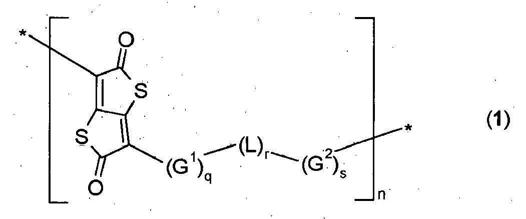 wherein
G¹ and G² are independently from each other C₆₋₁₄-arylene optionally substituted with 1 to 6 substituents R^{a} or bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, ₋OH, C₁₋₃₀-alkoxy, -O-CH₂CH₂O-C₁₋₃₀-alkyl, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
wherein
R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cyclo-, alkenyl, monovalent 3 to 14 membered aliphatic heterocyclic residue, C₆₋₁₄-aryl and monovalent 5 to14 membered aromatic heterocyclic residue,
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, ₋CONH₂, -CONHR³, -CONR³R⁴, -CO-H, -COR³, C₁₋₁₀alkyl, C₂₋₁₀-alkenyl, C₂₋₁₀alkynyl, C₆₋₁₄-aryl and monovalent 5 to 14 membered aromatic heterocyclic residue;
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
G¹ and G² are independently from each other 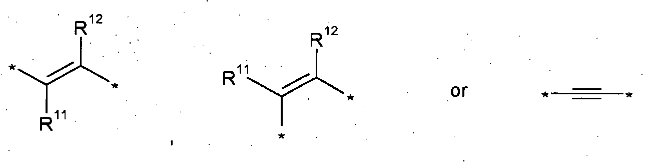 wherein
R¹¹ and R¹² are independently from each other H or C₁₋₃₀-alkyl,
L is C₆₋₂₄-arylene optionally substituted with 1 to 6 substituents R^{b} or bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -OCH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substitutents R^{e}, C₂₋₃₀-alkenyl optionally substituted with 1 to 6 substitutents R^{e}, C₂₋₃₀-alkynyl optionally substituted with 1 to 6 substitutents R^{e}, C₃₋₁₀-cycloalkyl optionally substituted with 1 to 6 substitutents R^{f}, C₅₋₁₀-cycloalkenyl optionally substituted with 1 to 6 substitutents R^{f} and monovalent 3 to 14 membered aliphatic heterocyclic residue optionally substituted with 1 to 6 substitutents R^{f},
wherein
R⁵ and R⁶ at each occurrence are independently from each other selected from the group consisting of C₁₋₃₀-alkyl, C₂₋₃₀-alkenyl, C₂₋₃₀-alkynyl, C₃₋₁₀cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR7R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R⁷ and R⁸ at each occurrence are independently from each other selected from the group consisting of C₁₋₁₀alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
L is 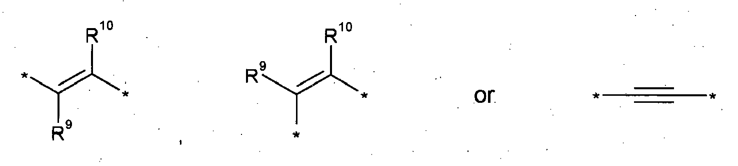 wherein
R⁹ and R¹⁰ are independently from each other H, C₁₋₃₀-alkyl, -CN or halogen,
q and s are independently from each other 0, 1, 2, 3, 4 or 5,
r is 0, 1 or 2,
and
n is an integer from 2 to 10'000.

2. The polymer of claim 1, wherein in the unit of formula (1)
G¹ and G² are independently from each other bivalent 5 to 14 membered aromatic heterocyclic residue optionally substituted with 1 to 6 substituents R^{a},
wherein
R^{a} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR¹, -S-C₁₋₃₀-alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-alkyl optionally substituted with 1 to 6 substituents R^{c}, C₂₋₃₀-alkenyl optionally substituted with 1 to 6 substituents R^{c}, C₂₋₃₀-alkynyl optionally substituted with 1 to 6 substituents R^{c}, C₃₋₁₀-cycloalkyl optionally substituted with 1 to 6 substituents R^{d}, C₅₋₁₀-cycloalkenyl optionally substituted with 1 to 6 substituents R^{d} and monovalent 3 to 14 membered aliphatic heterocyclic residue optionally substituted with 1 to 6 substituents R^{d},
wherein
R¹ and R² at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent, 5 to14 membered aromatic heterocyclic residue,
R^{c} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀-alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{d} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR³, -S-C₁₋₁₀alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-alkyl, C₂₋₁₀-alkenyl, C₂₋₁₀-alkynyl, C₆₋₁₄-aryl and monovalent 5 to 14 membered aromatic heterocyclic residue;
wherein R³ and R⁴ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue.

3. The polymer of claim 1, wherein in the unit of formula (1)
G¹ and G² are independently from each other monocyclic bivalent 5 to 8 membered aromatic heterocyclic residue optionally substituted with 1 to 4 substituents R^{a},
wherein
R^{a} at each occurrence are independently from each C₁₋₃₀-alkyl, preferably C₆₋₂₀-alkyl, more preferably C₈₋₁₆-alkyl.

4. The polymer of any of claims 1 to 3, wherein in the unit of formula (1)
L is bivalent 5 to 24 membered aromatic heterocyclic residue optionally substituted with 1 to 6 substituents R^{b},
wherein
R^{b} at each occurrence are independently from each other selected from the group consisting of =O, =C(CN)₂, -O-C₂₋₆-alkylene-O-, halogen, -CN, -NO₂, -OH, C₁₋₃₀-alkoxy, -O-CH₂CH₂O-C₁₋₃₀-alkyl, -O-COR⁵, -S-C₁₋₃₀-alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-alkyl optionally substituted with 1 to 6 substituents R^{e}, C₂₋₃₀-alkenyl optionally substituted with 1 to 6 substituents R^{e}, C₂₋₃₀-alkynyl optionally substituted with 1 to 6 substituents R^{e}, C₃₋₁₀-cycloalkyl optionally substituted with 1 to 6 substituents R^{f}, C₅₋₁₀-cycloalkenyl optionally substituted with 1 to 6 substituents R^{f} and monovalent 3 to 14 membered aliphatic heterocyclic residue optionally substituted with 1 to 6 substituents R^{f},
wherein
R⁵ and R⁶ at each occurrence are independently from each other selected from the group consisting of C₁₋₃₀-alkyl, C₂₋₃₀-alkenyl, C₂₋₃₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
R^{e} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-cycloalkyl, monovalent 3 to 14 membered aliphatic heterocyclic residue, C₆₋₁₄-aryl and monovalent 5 to 14 membered aromatic heterocyclic residue;
R^{f} at each occurrence are independently from each other selected from the group consisting of =O, =C(CN)₂, -O-C₂₋₆-alkylene-O-, halogen, -CN, -NO₂, -OH, C₁₋₁₀-alkoxy, -O-CH₂CH₂O-C₁₋₁₀-alkyl, -O-COR⁷, -S-C₁₋₁₀-alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₈alkyl, C₂₋₁₀-alkenyl, C₂₋₁₀-alkynyl, C₆₋₁₄-aryl and monovalent 5 to 14 membered aromatic heterocyclic residue;
wherein R⁷ and R⁸ at each occurrence are independently from each other selected from the group consisting of C₁₋₁₀-alkyl, C₂₋₁₀-alkenyl, C₂₋₁₀-alkynyl, C₃₋₁₀-cycloalkyl, C₅₋₁₀-cycloalkenyl, monovalent 3 to 14 membered aliphatic heterocyclic residue, C₆₋₁₄-aryl and monovalent 5 to14 membered aromatic heterocyclic residue,
or
L is 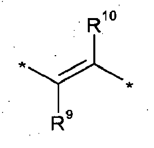 wherein
R⁹ and R¹⁰ are independently from each other H, C₁₋₃₀-alkyl, CN or halogen.

5. The polymer of any of claims 1 to 3, wherein in the unit of formula (1), wherein
L is monocyclic bivalent 5 to 8 membered aromatic heterocyclic residue optionally substituted with 1 to 4 substituents R^{b},
wherein
R^{b} at each occurrence are independently from each other C₁₋₃₀-alkyl.

6. The polymer of any of claims 1 to 5, wherein
q and s are both 1,
r is 2,
and
n is an integer from 5 to 10'000.

7. The polymer of claim 1, wherein the unit of formula (1) is a unit of formula 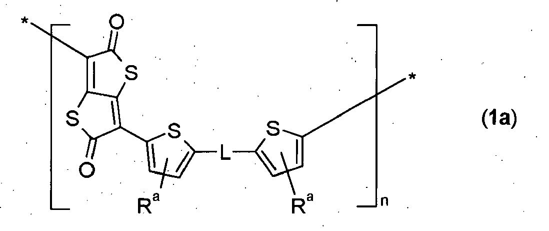 wherein R^{a} and L are as defined in claim 1.

8. The polymer of claim 7, wherein
L is 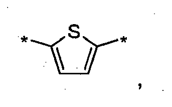 and R^{a} is as defined in claim 1.

9. The polymer of claim 7 or claim 8,
wherein R^{a} is as defined in claim 3.

10. The polymer of any of claims 1 to 9, wherein n is an integer from 5 to 5'000, more preferably from 5 to 1'000, even more preferably from 5 to 100, and most preferably from 10 to 100.

11. An electronic device comprising the polymer of any of claims 1 to 10 as semiconducting material.

12. The electronic device of claim 11, wherein the electronic device is an organic field effect transistor (OFET).

13. The electronic device of claim 11, wherein the electronic device is an organic photovoltaic device (OPV).

14. Use of the polymer of any of claims 1 to 10 as semiconducting material.

## Patentansprüche

1. Polymer, umfassend eine Einheit der Formel 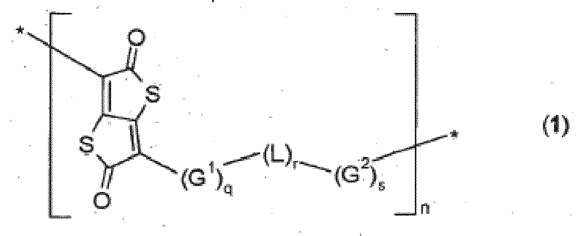 wobei
G¹ und G² unabhängig voneinander für C₆₋₁₄-Arylen, das gegebenenfalls durch 1 bis 6 Substituenten R^{a} substituiert ist, oder einen zweiwertigen 5- bis 14-gliedrigen aromatischen heterocyclischen Rest, der gegebenenfalls durch 1 bis 6 Substituenten R^{a} substituiert ist, stehen,
wobei
R^{a} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₃₀-Alkoxy, -O-CH₂CH₂O-C₁₋₃₀-Alkyl, -O-COR¹, -S-C₁₋₃₀-Alkyl, -NH₂, -NHR¹, -NR¹R², -NH-COR¹, -COOH, -COOR⁸, -CONH₂, -CONHR¹, -CONR¹R², -CO-H, -COR¹, C₁₋₃₀-Alkyl, das gegebenenfalls durch 1 bis 6 Substituenten R^{c} substituiert ist, C₂₋₃₀-Alkenyl, das gegebenenfalls durch 1 bis 6 Substituenten R^{c} substituiert ist, C₂₋₃₀-Alkinyl, das gegebenenfalls durch 1 bis 6 Substituenten R^{c} substituiert ist, C₃₋₁₀-Cycloalkyl, das gegebenenfalls durch 1 bis 6 Substituenten R^{d} substituiert ist, C₅₋₁₀-Cycloalkenyl, das gegebenenfalls durch 1 bis 6 Substituenten R^{d} substituiert ist und einem einwertigen 3- bis 14-gliedrigen aliphatischen heterocyclischen Rest, der gegebenenfalls durch 1 bis 6 Substituenten R^{d} substituiert ist, ausgewählt ist,
wobei
R¹ und R² bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{c} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{d} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R³ und R⁴ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind,
oder
G¹ und G² unabhängig voneinander für 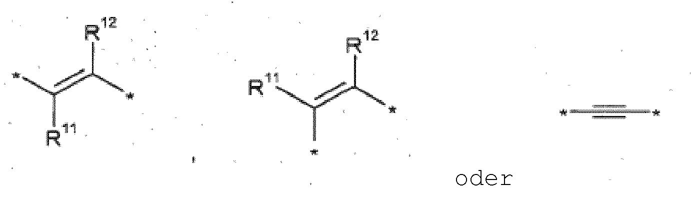 stehen, wobei
R¹¹ und R¹² unabhängig voneinander für H oder C₁₋₃₀-Alkyl stehen,
L für C₆₋₂₄-Arylen, das gegebenenfalls durch 1 bis 6 Substituenten R^{b} substituiert ist, oder einen zweiwertigen 5- bis 24-gliedrigen aromatischen heterocyclischen Rest, der gegebenenfalls durch 1 bis 6 Substituenten R^{b} substituiert ist, steht, wobei
R^{b} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₃₀-Alkoxy, -O-CH₂CH₂O-C₁₋₃₀-Alkyl, -O-COR⁵, -S-C₁₋₃₀-Alkyl, -NH₂, -NHR⁵, -NR⁵R⁶, -NH-COR⁵, -COOH, -COOR⁵, -CONH₂, -CONHR⁵, -CONR⁵R⁶, -CO-H_{,} -COR⁵, C₁₋₃₀-Alkyl, das gegebenenfalls durch 1 bis 6 Substituenten R^{e} substituiert ist, C₂₋₃₀-Alkenyl, das gegebenenfalls durch 1 bis 6 Substituenten R^{e} substituiert ist, C₂₋₃₀-Alkinyl, das gegebenenfalls durch 1 bis 6 Substituenten R^{e} substituiert ist, C₃₋₁₀-Cycloalkyl, das gegebenenfalls durch 1 bis 6 Substituenten R^{f} substituiert ist, C₅₋₁₀-Cycloalkenyl, das gegebenenfalls durch 1 bis 6 Substituenten R^{f} substituiert ist und einen einwertigen 3- bis 14-gliedrigen aliphatischen heterocyclischen Rest, der gegebenenfalls durch 1 bis 6 Substituenten R^{f} substituiert ist, ausgewählt ist,
wobei
R⁵ und R⁶ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cycloalkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{e} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR⁷, -S-C₁₋₁₀-Alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{f} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR⁷, -S-C₁₋₁₀-Alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R⁷ und R⁸ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind,
oder L für 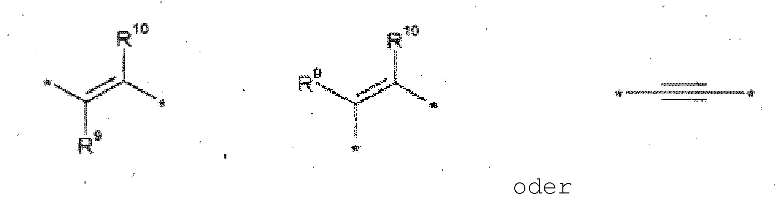 steht, wobei
R⁹ und R¹⁰ unabhängig voneinander für H, C₁₋₃₀-Alkyl, -CN oder Halogen stehen,
q und s unabhängig voneinander für 0, 1, 2, 3, 4 oder 5 stehen,
r für 0, 1 oder 2 steht
und
n für eine ganze Zahl von 2 bis 10.000 steht.

2. Polymer nach Anspruch 1, wobei in der Einheit der Formel **(1)**
G¹ und G² unabhängig voneinander für einen zweiwertigen 5- bis 14-gliedrigen aromatischen heterocyclischen Rest, der gegebenenfalls durch 1 bis 6 Substituenten R^{a} substituiert ist, stehen, wobei
R^{a} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₃₀-Alkoxy, -O-CH₂CH₂O-C₁₋₃₀-Alkyl, -O-COR¹, -S-C₁₋₃₀-Alkyl, -NH₂, -NHR¹, -NR¹R², -NH-COR¹, -COOH, -COOR¹, -CONH₂, -CONHR¹, -CONR¹R², -CO-H, -COR¹, C₁₋₃₀-Alkyl, das gegebenenfalls durch 1 bis 6 Substituenten R^{c} substituiert ist, C₂₋₃₀-Alkenyl, das gegebenenfalls durch 1 bis 6 Substituenten R^{c} substituiert ist, C₂₋₃₀-Alkinyl, das gegebenenfalls durch 1 bis 6 Substituenten R² substituiert ist, C₃₋₁₀-Cycloalkyl, das gegebenenfalls durch 1 bis 6 Substituenten R^{d} substituiert ist, C₅₋₁₀-Cycloalkenyl, das gegebenenfalls durch 1 bis 6 Substituenten R^{d} substituiert ist und einem einwertigen 3- bis 14-gliedrigen aliphatischen heterocyclischen Rest, der gegebenenfalls durch 1 bis 6 Substituenten R^{d} substituiert ist, ausgewählt ist,
wobei
R¹ und R² bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cyclo-alkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R² bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₃₋₁₀-Cycloalkyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt ist;
R^{d} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR³, -S-C₁₋₁₀-Alkyl, -NH₂, -NHR³, -NR³R⁴, -NH-COR³, -COOH, -COOR³, -CONH₂, -CONHR³, -CONR³R⁴, -CO-H, -COR³, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R³ und R⁴ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind.

3. Polymer nach Anspruch 1, wobei in der Einheit der Formel (1)
G¹ und G² unabhängig voneinander für einen monocyclischen zweiwertigen 5- bis 8-gliedrigen aromatischen heterocyclischen Rest, der gegebenenfalls durch 1 bis 4 Substituenten R^{a} substituiert ist, stehen,
wobei
R^{a} bei jedem Auftreten unabhängig voneinander für C₁₋₃₀-Alkyl, vorzugsweise C₆₋₂₀-Alkyl, weiter bevorzugt C₈₋₁₆-Alkyl, steht.

4. Polymer nach einem der Ansprüche 1 bis 3, wobei in der Einheit der Formel (1)
L für einen zweiwertigen 5- bis 24-gliedrigen aromatischen heterocyclischen Rest, der gegebenenfalls durch 1 bis 6 Substituenten R^{b} substituiert ist, steht,
wobei
R^{b} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₃₀-Alkoxy, -O-CH₂CH₂O-C₁₋₃₀-Alkyl, -O-COR⁵, -S-C₁₋₃₀-Alkyl, -NH₂, -NHR⁵, -NR⁵R⁶, -NH-COR⁵, -COOH, -COOR⁵, -CONH₂, -CONHR⁵, -CONR⁵R⁶, -CO-H, -COR⁵, C₁₋₃₀-Alkyl, das gegebenenfalls durch 1 bis 6 Substituenten R^{e} substituiert ist, C₂₋₃₀-Alkenyl, das gegebenenfalls durch 1 bis 6 Substituenten R^{e} substituiert ist, C₂₋₃₀-Alkinyl, das gegebenenfalls durch 1 bis 6 Substituenten R^{e} substituiert ist, C₃₋₁₀-Cycloalkyl, das gegebenenfalls durch 1 bis 6 Substituenten R^{f} substituiert ist, C₅₋₁₀-Cycloalkenyl, das gegebenenfalls durch 1 bis 6 Substituenten R^{f} substituiert ist und einen einwertigen 3- bis 14-gliedrigen aliphatischen heterocyclischen Rest, der gegebenenfalls durch 1 bis 6 Substituenten R^{f} substituiert ist, ausgewählt ist,
wobei
R⁵ und R⁶ bei jedem Auftreten unabhängig voneinander aus der Gruppe bestehend aus C₁₋₃₀-Alkyl, C₂₋₃₀-Alkenyl, C₂₋₃₀-Alkinyl, C₃₋₁₀-Cyclo-alkyl, C₅₋₁₀-Cycloalkenyl, einem einwertigen 3-bis 14-gliedrigen aliphatischen heterocyclischen Rest, C₆₋₁₄-Aryl und einem einwertigen 5-bis 14-gliedrigen aromatischen heterocyclischen Rest ausgewählt sind,
R^{e} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR⁷, -S-C₁₋₁₀-Alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₃₋₁₀-Cycloalkyl, einem einwertigen 3- bis 14-gliedrigen aliphatischen hetero-cyclischen Rest, C₆₋₁₄-Aryl und einem einwertigen 5- bis 14-gliedrigen aromatischen heterocyclischen Rest ausgewählt ist;
R^{f} bei jedem Auftreten unabhängig voneinander aus der Gruppe bestehend aus =O, =C(CN)₂, -O-C₂₋₆-Alkylen-O-, Halogen, -CN, -NO₂, -OH, C₁₋₁₀-Alkoxy, -O-CH₂CH₂O-C₁₋₁₀-Alkyl, -O-COR⁷, -S-C₁₋₁₀-Alkyl, -NH₂, -NHR⁷, -NR⁷R⁸, -NH-COR⁷, -COOH, -COOR⁷, -CONH₂, -CONHR⁷, -CONR⁷R⁸, -CO-H, -COR⁷, C₁₋₁₀-Alkyl, C₂₋₁₀-Alkenyl, C₂₋₁₀-Alkinyl, C₆₋₁₄-Aryl und einem einwertigen 5-bis 14-gliedrigen aromatischen heterocyclischen Rest ausgewählt ist;
wobei R⁷ und R⁸ bei jedem Auftreten unabhängig voneinander aus der Gruppe bestehend aus C₁₋₁₀-Alkyl, C₂₋₁₀-Alkenyl, C₂₋₁₀-Alkinyl, C₃₋₁₀-Cycloalkyl, C₅₋₁₀-Cycloalkenyl, einem einwertigen 3- bis 14-gliedrigen aliphatischen heterocyclischen Rest, C₆₋₁₄-Aryl und einem einwertigen 5- bis 14-gliedrigen aromatischen heterocyclischen Rest ausgewählt sind, oder L für 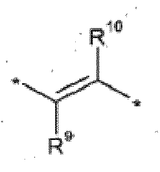 steht, wobei
R⁹ und R¹⁰ unabhängig voneinander für H, C₁₋₃₀-Alkyl, -CN oder Halogen stehen.

5. Polymer nach einem der Ansprüche 1 bis 3, wobei in der Einheit der Formel (1)
L für einen monocyclischen zweiwertigen 5- bis 8-gliedrigen aromatischen heterocyclischen Rest, der gegebenenfalls durch 1 bis 4 Substituenten R^{b} substituiert ist, steht,
wobei
R^{b} bei jedem Auftreten unabhängig voneinander für C₁₋₃₀-Alkyl steht.

6. Polymer nach einem der Ansprüche 1 bis 5, wobei
q und s beide für 1 stehen,
r für 2 steht
und
n für eine ganze Zahl von 5 bis 10.000 steht.

7. Polymer nach Anspruch 1, wobei es sich bei der Einheit der Formel (1) um eine Einheit der Formel 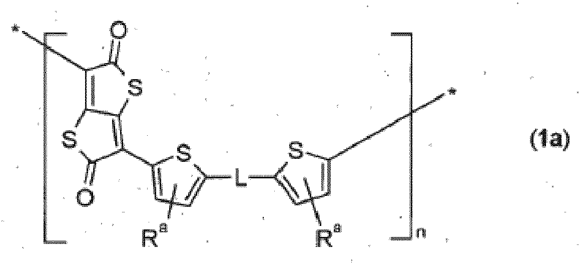 handelt, wobei R^{a} und L wie in Anspruch 1 definiert sind.

8. Polymer nach Anspruch 7, wobei L für 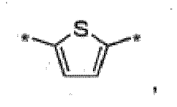 steht und R^{a} wie in Anspruch 1 definiert ist.

9. Polymer nach Anspruch 7 oder 8,
wobei R^{a} wie in Anspruch 3 definiert ist.

10. Polymer nach einem der Ansprüche 1 bis 9, wobei n für eine ganze Zahl von 5 bis 5000, vorzugsweise von 5 bis 1000, weiter bevorzugt von 5 bis 100 und ganz besonders bevorzugt von 10 bis 100 steht.

11. Elektronische Vorrichtung, umfassend das Polymer nach einem der Ansprüche 1 bis 10 als halbleitendes Material.

12. Elektronische Vorrichtung nach Anspruch 11, wobei es sich bei der elektronischen Vorrichtung um einen organischen Feldeffekttransistor (OFET) handelt.

13. Elektronische Vorrichtung nach Anspruch 11, wobei es sich bei der elektronischen Vorrichtung um eine organische Photovoltaikvorrichtung (OPV) handelt.

14. Verwendung des Polymers nach einem der Ansprüche 1 bis 10 als halbleitendes Material.

## Revendications

1. Polymère comprenant un motif de formule 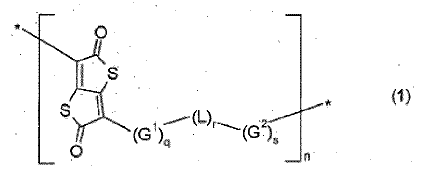 dans laquelle
G¹ et G² représentent indépendamment l'un de l'autre un arylène en C₆₋₁₄ éventuellement substitué par 1 à 6 substituants R³ ou un résidu hétérocyclique aromatique à 5 à 14 chaînons divalent éventuellement substitué par 1 à 6 substituants R^{a},
dans lesquels
les R^{a} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O- (alkyle en C₁₋₃₀), -O-COR¹, un radical -S-(alkyle en C₁₋₃₀), -NH₂, -NHR¹, -NR¹R², -NH-COR¹, -COOH, -COOR¹, -CONH₂, -CONHR¹, -CONR¹R², -CO-H, -COR¹, un alkyle en C₁₋₃₀ éventuellement substitué par 1 à 6 substituants R^{c}, un alcényle en C₂₋₃₀ éventuellement substitué par 1 à 6 substituants R^{c}, un alcynyle en C₂₋₃₀ éventuellement substitué par 1 à 6 substituants R^{c}, un cycloalkyle en C₃₋₁₀ éventuellement substitué par 1 à 6 substituants R^{d}, un cycloalcényle en C₅₋₁₀ éventuellement substitué par 1 à 6 substituants R^{d} et un résidu hétérocyclique aliphatique à 3 à 14 chaînons monovalent éventuellement substitué par 1 à 6 substituants R^{d},
dans lesquels
R¹ et R² à chaque occurrence sont choisis indépendamment l'un de l'autre dans le groupe constitué par un alkyle en C₁₋₃₀, un alcényle en C₂₋₃₀, un alcynyle en C₂₋₃₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{c} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S-(alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{d} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S- (alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R³ et R⁴ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
G¹ et G² représentent indépendamment l'un de l'autre 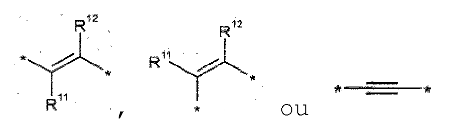 dans lesquels
R¹¹ et R¹² représentent indépendamment l'un de l'autre H ou un alkyle en C₁₋₃₀,
L représente un arylène en C₆₋₂₄ éventuellement substitué par 1 à 6 substituants R^{b} ou un résidu hétérocyclique aromatique à 5 à 24 chaînons divalent éventuellement substitué par 1 à 6 substituants R^{b},
dans lesquels
les R^{b} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O- (alkyle en C₁₋₃₀), -O-COR⁵, un radical -S-(alkyle en C₁₋₃₀), -NH₂, -NHR⁵, -NR⁵R⁶, -NH-COR⁵, -COOH, -COOR⁵, -CONH₂, -CONHR⁵, -CONR⁵R⁶, -CO-H, -COR⁵, un alkyle en C₁₋₃₀ éventuellement substitué par 1 à 6 substituants R^{e}, un alcényle en C₂₋₃₀ éventuellement substitué par 1 à 6 substituants R^{e}, un alcynyle en C₂₋₃₀ éventuellement substitué par 1 à 6 substituants R^{e}, un cycloalkyle en C₃₋₁₀ éventuellement substitué par 1 à 6 substituants R^{f}, un cycloalcényle en C₅₋₁₀ éventuellement substitué par 1 à 6 substituants R^{f} et un résidu hétérocyclique aliphatique à 3 à 14 chaînons monovalent éventuellement substitué par 1 à 6 substituants R^{f},
dans lesquels
R⁵ et R⁶ à chaque occurrence sont choisis indépendamment l'un de l'autre dans le groupe constitué par un alkyle en C₁₋₃₀, un alcényle en C₂₋₃₀, un alcynyle en C₂₋₃₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{e} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR⁷, un radical -S- (alkyle en C₁₋₁₀), -NH₂, -NHR⁷, -NR⁷R⁸, -NH-COR⁷, -COOH, -COOR⁷, -CONH₂, -CONHR⁷, -CONR⁷R⁸, -CO-H, -COR⁷, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{f} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR⁷, un radical -S- (alkyle en C₁₋₁₀), -NH₂, -NHR⁷, -NR⁷R⁸, -NH-COR⁷, -COOH, -COOR⁷, -CONH₂, -CONHR⁷, -CONR⁷R⁸, -CO-H, -COR⁷, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent, dans lesquels R⁷ et R⁸ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
L représente 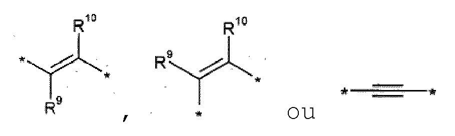 dans lesquels
R⁹ et R¹⁰ représentent indépendamment l'un de l'autre H, un alkyle en C₁₋₃₀, -CN ou un halogène,
q et s valent indépendamment l'un de l'autre 0, 1, 2, 3, 4 ou 5,
r vaut 0, 1 ou 2,
et
n est un entier de 2 à 10 000.

2. Polymère selon la revendication 1 dans lequel, dans le motif de formule (1),
G¹ et G² représentent indépendamment l'un de l'autre un résidu hétérocyclique aromatique à 5 à 14 chaînons divalent éventuellement substitué par 1 à 6 substituants R^{a},
dans lequel
les R³ à chaque occurrence sont choisis indépendamment les uns des autres dans le groupe constitué par =O, =C(CN)₂, un radical -O-(alkylène en C₂₋₆) -O-, un halogène, -CN, -NO₂, -OH, un alcoxy en C₁₋₃₀, un radical -O-CH₂CH₂O- (alkyle en C₁₋₃₀), -O-COR¹, un radical -S-(alkyle en C₁₋₃₀), -NH₂, -NHR¹, -NR¹R², -NH-COR¹, -COOH, -COOR¹, -CONH₂, -CONHR¹, -CONR¹R², -CO-H, -COR¹, un alkyle en C₁₋₃₀ éventuellement substitué par 1 à 6 substituants R^{c}, un alcényle en C₂₋₃₀ éventuellement substitué par 1 à 6 substituants R^{c}, un alcynyle en C₂₋₃₀ éventuellement substitué par 1 à 6 substituants R², un cycloalkyle en C₃₋₁₀ éventuellement substitué par 1 à 6 substituants R^{d}, un cycloalcényle en C₅₋₁₀ éventuellement substitué par 1 à 6 substituants R^{d} et un résidu hétérocyclique aliphatique à 3 à 14 chaînons monovalent éventuellement substitué par 1 à 6 substituants R^{d},
dans lesquels
R¹ et R² à chaque occurrence sont choisis indépendamment l'un de l'autre dans le groupe constitué par un alkyle en C₁₋₃₀, un alcényle en C₂₋₃₀, un alcynyle en C₂₋₃₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{c} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S- (alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{d} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR³, un radical -S- (alkyle en C₁₋₁₀), -NH₂, -NHR³, -NR³R⁴, -NH-COR³, -COOH, -COOR³, -CONH₂, -CONHR³, -CONR³R⁴, -CO-H, -COR³, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R³ et R⁴ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent.

3. Polymère selon la revendication 1 dans lequel, dans le motif de formule (1),
G¹ et G² représentent indépendamment l'un de l'autre un résidu hétérocyclique aromatique à 5 à 8 chaînons divalent monocyclique éventuellement substitué par 1 à 4 substituants R³,
dans lequel
les R³ à chaque occurrence représentent indépendamment les uns des autres un alkyle en C₁₋₃₀, de préférence un alkyle en C₆₋₂₀, mieux un alkyle en C₈₋₁₆.

4. Polymère selon l'une quelconque des revendications 1 à 3 dans lequel, dans le motif de formule (1),
L représente un résidu hétérocyclique aromatique à 5 à 24 chaînons divalent éventuellement substitué par 1 à 6 substituants R^{b},
dans lequel
les R^{b} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₃₀, un radical -O-CH₂CH₂O- (alkyle en C₁₋₃₀), -O-COR⁵, un radical -S-(alkyle en C₁₋₃₀), -NH₂, -NHR⁵, -NR⁵R⁶, -NH-COR⁵, -COOH, -COOR⁵, -CONH₂, -CONHR⁵, -CONR⁵R⁶, -CO-H, -COR⁵, un alkyle en C₁₋₃₀ éventuellement substitué par 1 à 6 substituants R^{e}, un alcényle en C₂₋₃₀ éventuellement substitué par 1 à 6 substituants R^{e}, un alcynyle en C₂₋₃₀ éventuellement substitué par 1 à 6 substituants R^{e}, un cycloalkyle en C₁₋₁₀ éventuellement substitué par 1 à 6 substituants R^{f}, un cycloalcényle en C₅₋₁₀ éventuellement substitué par 1 à 6 substituants R^{f} et un résidu hétérocyclique aliphatique à 3 à 14 chaînons monovalent éventuellement substitué par 1 à 6 substituants R^{f},
dans lesquels
R⁵ et R⁶ à chaque occurrence sont choisis indépendamment l'un de l'autre dans le groupe constitué par un alkyle en C₁₋₃₀, un alcényle en C₂₋₃₀, un alcynyle en C₂₋₃₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{e} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR⁷, un radical -S-(alkyle en C₁₋₁₀), -NH₂, -NHR⁷, -NR⁷R⁸, -NH-COR⁷, -COOH, -COOR⁷, -CONH₂, -CONHR⁷, -CONR⁷R⁸, -CO-H, -COR⁷, un cycloalkyle en C₃₋₁₀, un résidu hétérocyclique aliphatique à 3 à 14 chaînons monovalent, un aryle en C₆₋₁₄ et un résidu hétérocyclique aromatique à 5 à 14 chaînons monovalent ;
les R^{f} à chaque occurrence sont choisis indépendamment les uns des autres dans le groupe constitué par =O, =C(CN)₂, un radical -O-(alkylène en C₂₋₆)-O-, un halogène, -CN, -NO₂, -OH, un alcoxy en C₁₋₁₀, un radical -O-CH₂CH₂O- (alkyle en C₁₋₁₀), -O-COR⁷, un radical -S-(alkyle en C₁₋₁₀), -NH₂, -NHR⁷, -NR⁷R⁸, -NH-COR⁷, -COOH, -COOR⁷, -CONH₂, -CONHR⁷, -CONR⁷R⁸, -CO-H, -COR⁷, un alkyle en C₁₋₁₀, un alcényle en C₂₋₁₀, un alcynyle en C₂₋₁₀, un aryle en C₆₋₁₄ et un résidu hétérocyclique aromatique à 5 à 14 chaînons monovalent,
dans lesquels R⁷ et R⁸ à chaque occurrence sont choisis indépendamment l'un de l'autre dans le groupe constitué par un alkyle en C₁₋₁₀, un alcényle en C₂₋₁₀, un alcynyle en C₂₋₁₀, un cycloalkyle en C₃₋₁₀, un cycloalcényle en C₅₋₁₀, un résidu hétérocyclique aliphatique à 3 à 14 chaînons monovalent, un aryle en C₆₋₁₄ et un résidu hétérocyclique aromatique à 5 à 14 chaînons monovalent,
ou bien
L représente 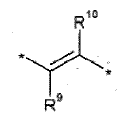 dans lequel
R⁹ et R¹⁰ représentent indépendamment l'un de l'autre H, un alkyle en C₁₋₃₀, CN ou un halogène.

5. Polymère selon l'une quelconque des revendications 1 à 3 dans lequel, dans le motif de formule (1),
L représente un résidu hétérocyclique aromatique à 5 à 8 chaînons divalent monocyclique éventuellement substitué par 1 à 4 substituants R^{b},
dans lequel
les R^{b} à chaque occurrence représentent indépendamment les uns des autres un alkyle en C₁₋₃₀.

6. Polymère selon l'une quelconque des revendications 1 à 5, dans lequel
q et s valent tous deux 1,
r vaut 2,
et
n est un entier de 5 à 10 000.

7. Polymère selon la revendication 1, dans lequel le motif de formule (1) est un motif de formule 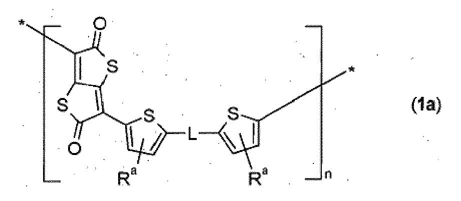 dans laquelle R^{a} et L sont tels que définis dans la revendication 1.

8. Polymère selon la revendication 7, dans lequel L représente 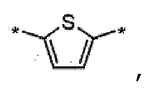 et R^{a} est tel que défini dans la revendication 1.

9. Polymère selon la revendication 7 ou la revendication 8,
dans lequel R^{a} est tel que défini dans la revendication 3.

10. Polymère selon l'une quelconque des revendications 1 à 9, dans lequel n est un entier de 5 à 5000, de préférence de 5 à 1000, mieux de 5 à 100, et idéalement de 10 à 100.

11. Dispositif électronique comprenant le polymère de l'une quelconque des revendications 1 à 10 en tant que matériau semi-conducteur.

12. Dispositif électronique selon la revendication 11, le dispositif électronique étant un transistor à effet de champ organique (OFET).

13. Dispositif électronique selon la revendication 11, le dispositif électronique étant un dispositif photovoltaïque organique (OPV).

14. Utilisation du polymère de l'une quelconque des revendications 1 à 10 comme matériau semi-conducteur.
